Europäisches Patentamt

European Patent Office

Office européen des brevets

(11) Publication number: **0 230 648 B1**

# EUROPEAN PATENT SPECIFICATION

(45) Date of publication of patent specification: **25.03.92**  (51) Int. Cl.⁵: **H01L 21/00**, H01L 23/00

(21) Application number: **86117956.2**

(22) Date of filing: **23.12.86**

(54) **Method of forming an alignment mark.**

(30) Priority: **27.12.85 JP 296922/85**

(43) Date of publication of application:
**05.08.87 Bulletin 87/32**

(45) Publication of the grant of the patent:
**25.03.92 Bulletin 92/13**

(84) Designated Contracting States:
**DE FR GB**

(56) References cited:
US-A- 3 562 536
US-A- 4 090 068
US-A- 4 095 095
US-A- 4 407 933

IEEE TRANSACTIONS ON ELECTRON DEVICES, vol. ED-25, no. 4, April 1978, pages 419-424, IEEE, New York, US; B.J. LIN: "A Double-exposure technique to macroscopically control submicrometer linewidths in positive resist images"

SOLID STATE TECHNOLOGY, vol. 28, no. 5, May 1985, pages 229-235, Port Washington, New York, US; C. ALCORN et al.: "Kerf test structure designs for process and device characterization"

(73) Proprietor: **NEC CORPORATION**
**7-1, Shiba 5-chome Minato-ku**
**Tokyo 108-01(JP)**

(72) Inventor: **Honto, Nobuo c/o NEC Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

## Description

The present invention relates to a method of forming an alignment mark for a semiconductor wafer.

Generally, in the fabrication of semiconductor elements, at plural steps, it is necessary to precisely align positions of a pattern on the wafer and a photomask pattern to print out a predetermined pattern.

Conventionally, there was employed a method such that an operator directly observes a pattern on the wafer and a photomask pattern through a microscope to effect the alignment of the photomask. On the other hand, after reduction projection type aligners have been used according as demand for miniaturization of semiconductor elements is increased in recent years, various mechanisms which automatically effect alignment of the mask (reticle) and the wafer have been adopted.

At present, there is known a method to use an alignment mark on the wafer as one of wafer automatic aligning methods used in the reduction projection type aligner. This method applies an image processing based on contrast to the alignment mark for wafer using a camera etc. to conduct pattern recognition, thus to effect automatic mask alignment. Such a example is disclosed in the paper titled "A double-exposure technique to macroscopically control submicrometer linewidths in positive resist image" (IEEE transaction on electron device, vol. ED 25, No 4, April, 1978) and also in US-A-4090068. However, the drawback with this method is that the contrast of the alignment mark becomes indistinct according as the manufacturing process advances and thus discrepancy in the alignment or the like occurs, with the result that it takes much time in alignment.

For overcoming this drawback, there is known a method to use a plane reflection type diffraction grating as the alignment mark. In this method, a laser beam is irradiated to the alignment mark, thereby to recognize the alignment mark by receiving a diffracted light from the mark. Namely, even if the fabrication process progresses and the surface material etc. is changed, as long as the offset of the plane reflection type diffraction grating is preserved, this method advantageously makes it possible to reduce alignment error and time required for alignment as compared to the above-mentioned method based on the image processing.

Since the aligning method using the above-mentioned plane reflection type diffraction grating as the alignment mark utilizes the reflected light from the alignment mark, accuracy of the alignment greatly depends upon the alignment mark and the quality and form of the material thereon.

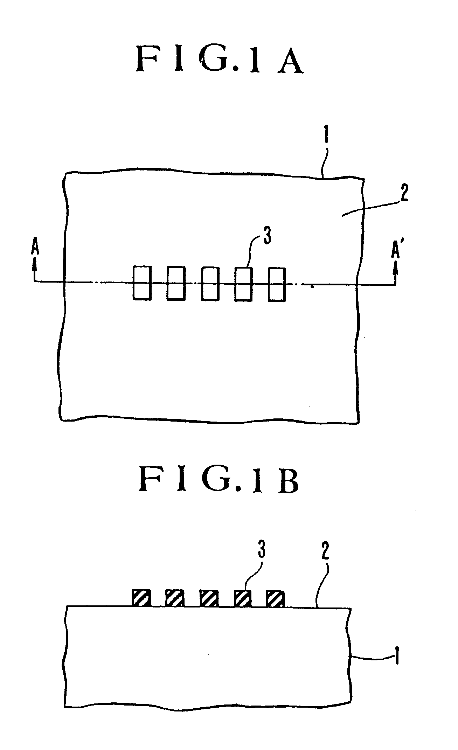

Ordinarily, the alignment marks are made up by etching an silicon oxide film or a polycrystalline silicon film and they are often formed on a scribe line region of the wafer for the purpose of reducing the chip area. For the scribe line region, it is required to employ a structure such that the silicon substrate is exposed for the purpose of ensuring a conduction between the circuit on the chip and the silicon substrate. Heretofore, the plane reflection type diffraction grating used for the alignment mark was fabricated by leaving silicon oxide film 3 or polycrystalline silicon film on the scribe line region 2 of silicon wafer 1, as shown in Figs. 1A and 1B.

However, in the case where an aluminum film is formed on the alignment mark, since the step coverage of aluminum deposited on the projection of the mark is bad, the form of the mark becomes indistinct and a reflected light for aligning is disturbed, with the result that error in the detection of the alignment mark becomes large.

Summary of the Invention

An object of the present invention is to provide a method of forming an alignment mark for a semiconductor wafer wherein even when aluminum is deposed on the alignment mark, this method permits the form of the alignment mark to be clearly left and the alignment accuracy to be improved.

A method of forming the alignment mark for a semiconductor wafer according to the present invetion comprises the steps of forming an insulating film on the scribe line region of the semiconducter wafer, and then providing a plurality of parallel grooves in the insulating film to form a plane reflection type diffraction grating which is used as the alignment mark. A semiconductor wafer having such an alignment mark is set out in Claim 4.

Brief description of the Drawings

Figs. 1A and 1B are a plan view and a cross sectional view for explaining a conventional semiconductor wafer aligning method, respectively, and
Figs. 2A, 2B, 3A and 3B are views for explaining a semiconductor wafer aligning method according to the present invention.

Detailed description of preferred Embodiment

A preferred embodiment according to the present invention will be described with reference to attached drawings.

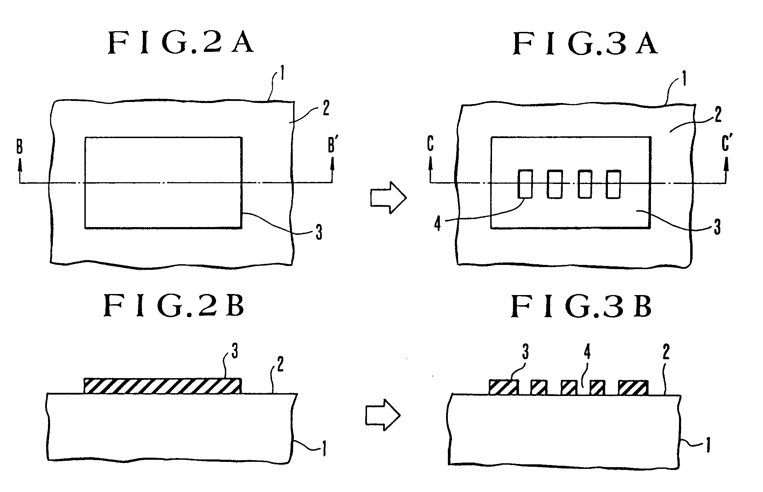

Fig. 2A is a plan view for explaining a first step in the embodiment according to the present invention and Fig. 2B is a cross sectional view taken along the lines B-B' of Fig. 2A. In addition, Fig. 3A is a plan view for explaining a second step in the embodiment according to the present invention and Fig. 3B is a cross sectional view taken along lines C-C' of Fig. 3A.

As shown in Figs. 2A and 2B, a silicon oxide film 3 is first formed on the scribe line region 2 provided on the silicon wafer 1. Then as shown in Figs. 3A and 3B, a plurality of parallel grooves 4 are provided by patterning the silicon oxide film 3 to form a plane reflection type diffraction grating. This grating is used as the alignment mark for the silicon wafer 1.

The parallel grooves 4 as the alignment mark thus formed are formed in the silicon oxide film 3 having a relatively large area. Accordingly, even when an aluminum film is formed on the surface of the silicon wafer 1, the grain boundary of aluminum has small influence on the alignment mark and the step coverage also becomes preferable, with the result that the alignment mark which is clear in shape is left.

Accordingly, a reflected light of the irradiated laser beam is detected with less distortion, differently from the behavior of the reflected light in the case where aluminum is deposited on the silicon oxide film 3 projectedly formed on the silicon surface as in the prior art. Thus detection accuracy of the alignment mark is improved.

As a result of execution of alignment of the silicon wafer using the alignment mark formed according to the present embodiment, alignment accuracy has been improved by more than two times as compared to the case where the conventional alignment mark is used.

It is to be noted that since the formation of the silicon oxide film 3 and the formation of the grooves 4 in the above-mentioned embodiment are all implemented by making use of the process for forming semiconductor elements, no special process is required. In addition, while it has been described that the silicon oxide film 3 is used for forming the grooves 4, other insulating films such as silicon nitride and polycrystalline silicon film may be use.

As described above, the present invention is implemented so that the plane reflection type diffraction grating used as the alignment mark is constituted with grooves formed in the insulating film. Thus, even when aluminum is deposited on the surface of the alignment mark, the present invention enables an implementation such that an alignment mark which is clear in shape is left, thus providing an alignment mark for semiconductor wafer having improved alignment accuracy.

## Claims

1. A method for forming an alignment mark for a semiconductor wafer comprising the step of forming an insulating film (3) on a scribe line (2) region of said semiconductor wafer (1), and providing a plurality of parallel grooves (4) in said insulating film (3) to form a plane reflection type diffraction grating which is used for said alignment mark.

2. A method of forming an alignment mark according to claim 1, wherein the material of said insulating film (3) is one selected from silicon oxide, silicon nitride, and polycrystalline silicon.

3. A method of forming an alignment mark according to claim 1, wherein the steps of forming said insulating film (3) and providing said grooves (4) are implemented in a process of forming semiconductor elements.

4. A semiconductor wafer having an alignment mark, said alignment mark comprising an insulating film (3) on a scribe line region (2) of said semiconductor wafer (1) and a plurality of parallel grooves (4) in said insulating film (3) forming a plane reflection type diffraction grating.

## Revendications

1. Procédé pour former une marque d'alignement dans un corps semi-conducteur comprenant l'étape consistant à former un film isolant (3) sur une région de ligne de séparation (2) du corps semi-conducteur (1) et la formation d'une multitude de rainures parallèles (4) dans le film isolant (3) pour former un réseau de diffraction de type à réflexion plane qui est utilisé pour la marque d'alignement.

2. Procédé de formation d'une marque d'alignement selon la revendication 1, dans lequel le matériau du film isolant (3) est l'un choisi parmi l'oxyde de silicium, le nitrure de silicium et le silicium polycristallin.

3. Procédé de formation d'une marque d'alignement selon la revendication 1, dans lequel les étapes consistant à former le film isolant (3) et à réaliser les rainures (4) sont mises en oeuvre dans un procédé de formation d'éléments semi-conducteurs.

4. Corps semi-conducteur comportant une marque d'alignement, la marque d'alignement comprenant un film isolant (3) sur une région de ligne de séparation (2) du corps semi-conducteur (1) et une multitude de rainures parallèles (4) dans le film isolant (3) formant un réseau de diffraction du type à réflexion plane.

**Patentansprüche**

1. Verfahren zur Ausbildung einer Ausrichtmarke für einen Halbleiterkörper mit den Schritten zur Bildung eines isolierenden Films (3) in einem Trennlinienbereich (2) des Halbleiterkörper und der Schaffung einer Anzahl paralleler Nuten (4) in dem isolierenden Film (3) zur Ausbildung eines Planreflektions-Beugungsgitters, das als Ausrichtmarke verwendet wird.

2. Verfahren zur Ausbildung einer Ausrichtmarke nach Anspruch 1, wobei das Material des isolierenden Films (3) ausgewählt ist aus Siliziumoxid, Siliziumnitrid oder polykristallinem Silizium.

3. Verfahren zur Bildung einer Ausrichtmarke nach Anspruch 1, wobei die Schritte zur Ausbildung des isolierenden Films (3) und zur Ausbildung der Nuten (4) in einem Prozeß zur Herstellung von Halbleiterelementen implementiert sind.

4. Halbleiterkörper mit einer Ausrichtemarke, wobei die Ausrichtmarke einen isolierenden Film (3) auf einem Trennlinienbereich (2) des Halbleiterkörpers (1) aufweist und eine Anzahl von parallelen Nuten (4) in dem isolierenden Film (3) ein Planreflektions-Beugungsgitter bildet.

# FIG.1A

# FIG.1B

# FIG.2A

# FIG.3A

# FIG.2B

# FIG.3B

EP 0 230 648 B1